# EUROPEAN PATENT SPECIFICATION

(11) **EP 3 723 462 B1**
(45) Date of publication and mention of the grant of the patent: **22.06.2022**
(21) Application number: 19168055.2
(22) Date of filing: 09.04.2019
(51) Int. Cl.: H05K 7/20

(54) **COOLING SYSTEM, IN PARTICULAR FOR ELECTRONICS CABINETS, AND ELECTRONICS CABINET WITH A COOLING SYSTEM**
KÜHLSYSTEM, INSBESONDERE FÜR ELEKTRONIKSCHRÄNKE UND ELEKTRONIKSCHRANK MIT EINEM KÜHLSYSTEM
SYSTÈME DE REFROIDISSEMENT, EN PARTICULIER POUR ARMOIRES ÉLECTRONIQUES ET ARMOIRE ÉLECTRONIQUE DOTÉ D'UN SYSTÈME DE REFROIDISSEMENT

(43) Date of publication of application: 14.10.2020
(73) Proprietor: Pfannenberg GmbH, 21035 Hamburg (DE)
(72) Inventor: Fuller, Russell, Lancaster, NY New York 14086 (US); STARP, Peter, 21035 Hamburg (DE); MARLOW, Christopher, Lancaster, NY New York 14086 (US); HALM, Nils Peter, 21035 Hamburg (DE)
(74) Representative: RGTH

(56) References cited:
- CN-U- 202 561 932
- KOSOY B: "Heat Pipes", 1 January 2004 (2004-01-01), KIRK-OTHMER ENCYCLOPEDIA OF CHEMICAL TECHNOLOGY (4TH EDITION), WILEY-INTERSCIENCE, HOBOKEN, NJ, USA, PAGE(S) 225 - 241, XP002546842, ISBN: 978-0-471-48494-3 [retrieved on 2004-11-19] * pages 225-227, paragraphs 1,2 * * page 235, paragraph 6 *

## Description

The present invention relates to a cooling system, in particular for electronics cabinets, comprising a casing, wherein the cooling system comprises a first cooling circuit and a second cooling circuit, the first cooling circuit comprising a heat releasing section and the second cooling circuit comprising a heat releasing section. Furthermore, the present invention relates to an electronics cabinet comprising a cooling system.

### Technological background

Cooling systems are used in a wide range of technical applications. One particular example is the use of cooling system for cooling electronics cabinets such as switchboards, control cabinets, enclosure systems or computer systems, or generally for cooling any housing enclosing heat producing components. Such cooling systems usually comprise a cooling circuit, which can either be configured as a passive cooling circuit or as an active cooling circuit.

Prior art document WO 2014/032649 A1 discloses a switch cabinet having a cooling device which has a first closed coolant circuit and a second closed coolant circuit fluidically separated from the first coolant circuit, wherein the first coolant circuit has a refrigeration device or a chilled water unit and the second coolant circuit has a heat pipe arrangement.

WO 2014/032654 A1 discloses a heat exchanger for cooling a switch cabinet, having a first pipe system for a first coolant and a second pipe system for a second coolant, which pipe system is fluidically separated from the first pipe system, wherein the first and the second pipe systems are thermally coupled to one another.

DE 10 2012 108 108 A1 discloses a switch cabinet with a cooling device comprising a first airflow path, through which ambient air is guided, and a second airflow path fluidically separated from the first airflow path and through which air from an interior of the switch cabinet is guided. A first section of an air-to-air heat exchanger is disposed in the first airflow path and a second section of the air-to-air heat exchanger is disposed in the second airflow path.

EP 3 407 693 A1 discloses a heat exchanger for cooling an electronic enclosure, wherein the heat exchanger has a condenser side and an evaporator side and wherein the condenser side and the evaporator side of the heat exchanger are separated from each other by a barrier.

CN 103 491 733 A discloses a cabinet with a combination of active and passive cooling systems.

CN 202 561 932 U1 discloses an air conditioner for a base station of a mobile communications network. The air conditioner comprises a vapour compression refrigeration system and a heat pipe. The air conditioner further comprises an indoor unit and an outdoor unit. The indoor unit comprises an upper chamber provided with a vapour compression refrigeration system evaporator and a lower chamber with a heat pipe evaporator. The outdoor unit comprises an upper chamber provided with a heat pipe condenser and a lower chamber with a vapour compression refrigeration system condenser. Both the indoor unit and the outdoor unit comprise a partition wall between their respective upper and lower chambers.

In cooling systems comprising a first cooling circuit and a second cooling circuit, each of the cooling circuits having a heat absorbing section and a heat releasing section, an airflow passing over the heat absorbing section of the first cooling circuit subsequently passes over the heat absorbing section of the second cooling circuit and, similarly, an airflow passing over the heat releasing section of the first cooling circuit subsequently also passes over the heat releasing section of the second cooling circuit. The sequential arrangement of the heat absorbing sections and of the heat releasing sections of the first and the second cooling circuit in the same airflow paths results in high pressure drops requiring larger fans to work against said pressure drop.

### Disclosure of the invention: problem, solution, advantages

It is an object of the present invention to provide a cooling system according to claim 1, in particular for electronics cabinets, comprising a first cooling circuit and a second cooling circuit, which provides a more efficient and less energy demanding heat transfer, in particular from the interior to the exterior of the electronics cabinet. Furthermore, it is an object of the present invention to provide an electronics cabinet according to claim providing the same benefits.

To solve the object of the invention a cooling system, in particular for electronics cabinets, is proposed, comprising a casing, wherein the cooling system comprises a first cooling circuit and a second cooling circuit, the first cooling circuit comprising a heat releasing section and the second cooling circuit comprising a heat releasing section, wherein the first cooling circuit comprises a heat absorbing section and wherein the second cooling circuit comprises a heat absorbing section, wherein the casing comprises at least three compartments including a cabinet side compartment, a first external side compartment and a second external side compartment, wherein the three compartments are fluidically separated from each other so that respective airflows in the cabinet side compartment, the first external side compartment and the second external side compartment do not mix, wherein the heat releasing section of the first cooling circuit is arranged in the first external side compartment and wherein the heat releasing section of the second cooling circuit is arranged in the second external side compartment, and wherein the heat absorbing section of the first cooling circuit and the heat absorbing section of the second cooling circuit are arranged in the cabinet side compartment, and wherein the heat absorbing section of the first cooling circuit is disposed in the direction of an airflow in the cabinet side compartment in front of the heat absorbing section of the second cooling circuit, or wherein the heat absorbing section of the first cooling circuit is arranged in the cabinet side compartment and wherein the heat absorbing section of the second cooling circuit is arranged in the first external side compartment and thermally coupled to the heat releasing section of the first cooling circuit.

The casing may comprise separation walls fluidically separating the at least three compartments from each other, so that respective airflows in the cabinet side compartment, the first external side compartment and the second external side compartment do not mix. Therefore, it is preferred that the separation walls between the cabinet side compartment, the first external side compartment and the second side compartment essentially completely prevent air from any one of the at least three compartments to enter any other of the at least three compartments.

The separation walls separating the three compartments maybe configured essentially gastight.

By arranging the heat releasing section of the first cooling circuit in the first external side compartment and the heat releasing section of the second cooling circuit in the second external side compartment, an airflow passing over the heat releasing section of the first cooling circuit to remove heat released by said heat releasing section does not pass over the heat releasing section of the second cooling circuit. Thus, the heat releasing section of the second cooling circuit is not warmed by the heat released from the heat releasing section of the first cooling circuit. The second cooling circuit therefore can be operated more effectively compared to prior art cooling system, in which the warming of the heat releasing section of the second cooling circuit reduces the cooling power of the second cooling circuit. In addition, since the airflow passing over the heat releasing section of the first cooling circuit does not pass over the heat releasing section of the second cooling circuit, the pressure drop resulting from a staging of the heat releasing sections of the first and the second cooling circuit is reduced, so that fans to drive the airflows can be configured smaller and less energy consuming than in prior art.

The cooling system is preferably configured for use with electronics cabinets. However, it is within the scope of the present invention that the cooling system can be used with any housing enclosing heat producing components.

Preferably the cabinet side compartment is fluidically connectable or connected to an interior of an electronics cabinet, and/or the first external side compartment is fluidically connectable or connected to an exterior of an electronics cabinet, and/or the second external side compartment is fluidically connectable or connected to an exterior of an electronics cabinet.

The cabinet side compartment may comprise an inlet and an outlet opening for air from an interior of an electronics cabinet to enter and exit the cabinet side compartment.

When the cooling system is connected to an electronics cabinet, heated air from the interior of the electronics cabinet may enter the cabinet side compartment through the inlet opening and exit the cabinet side compartment through the outlet opening to return to the interior of the electronics cabinet.

Similarly, the first and the second external side compartments may comprise respective inlet and outlet openings for exterior or ambient air to enter the first or second external side compartment through the respective inlet opening and to exit the first or the second external side compartment through the respective outlet opening.

Thus, heated air from the interior of the electronics cabinet can circulate through the cabinet side compartment and external or ambient air can circulate independently through the first external side compartment and the second external side compartment without the airflows in the cabinet side compartment, the first external side compartment and the second external side compartment mixing.

Preferably the first cooling circuit is a passive cooling circuit, in particular a heat pipe, a thermosiphon, or a pulsating heat pipe, wherein the heat releasing section of the first cooling circuit furthermore preferably is a condensing side of the passive cooling circuit.

However, the first cooling circuit may also be configured as a fluid cooling circuit such as a water cooling circuit or any other passive cooling circuit.

The second cooling circuit may be configured as an active cooling circuit, in particular a vapor compression cycle circuit, wherein preferably the heat releasing section of the second cooling circuit is a condenser of the active cooling circuit.

In context of the present invention, an active cooling circuit is a cooling circuit that requires the use of energy to transfer heat, for example from a region of a lower temperature to a region of higher temperature. An example for an active cooling circuit is a vapor compression cycle cooling circuit. Thus, an active cooling circuit is a cooling circuit that may comprise a compressor or the like. In contrast, a passive cooling circuit is a cooling circuit that transfers heat from a region of higher temperature to a region of lower temperature spontaneously. Examples of passive cooling systems are heat pipes, thermosiphons, pulsating heat pipes or water cooling systems. Passive cooling system may include supporting components requiring auxiliary energy such as fans or, in particular in the case of water cooling systems, pumps to circulate a coolant or refrigerant. However, the auxiliary energy used in these systems is only required to drive the supporting components, while the heat flow is strictly passive and spontaneous from the region of higher temperature to the region of lower temperature.

It is particularly preferred that the first cooling circuit is a passive cooling circuit and that the second cooling circuit as an active cooling circuit. The combination of a passive cooling circuit with an active cooling circuit allows for an efficient operation of the cooling system.

For example, when the interior temperature of the electronics cabinet is higher than the exterior or ambient temperature only the passive cooling circuit of the cooling system may be operated. If expedient, the active cooling circuit can be operated additionally as a supporting cooling circuit. When the interior temperature of the electronics cabinet is lower than the exterior or ambient temperature only the active cooling circuit is operated.

The heat absorbing section of the first cooling circuit and the heat absorbing section of the second cooling circuit are arranged in the cabinet side compartment, wherein the heat absorbing section of the first cooling circuit is disposed in the direction of an airflow in the cabinet side compartment in front of the heat absorbing section of the second cooling circuit.

When in operation, an airflow will be generated or develop in the cabinet side compartment of the cooling system. Air can flow through an inlet opening into the cabinet side compartment, circulate through the cabinet side compartment and leave the cabinet side compartment through an outlet opening. With regard to the direction of the airflow in the cabinet side compartment, the heat absorbing section of the first cooling circuit can be disposed in front of the heat absorbing section of the second cooling circuit. In particular, when the heat absorbing section of the first cooling circuit is an evaporating side of a passive cooling circuit such as a heat pipe, a pulsating heat pipe or a thermosiphon, and when the heat absorbing section of the second cooling circuit is an evaporator of an active cooling circuit such as a vapor compression cycle circuit, the arrangement of the heat absorbing section of the first cooling circuit in front of the heat absorbing section of the second cooling circuit is particularly beneficial. Since the heated air from the interior of the electronics cabinet passing over the evaporating side of the passive first cooling circuit has not been cooled by the evaporator of the active second cooling circuit, the first passive cooling circuit is subjected to a high temperature delta between the interior of the electronics cabinet and the ambient or exterior air of the electronics cabinet. Thus, the first cooling circuit can remove heat more efficiently.

Alternatively, the heat absorbing section of the first cooling circuit is arranged in the cabinet side compartment and the heat absorbing section of the second cooling circuit is arranged in the first external side compartment and thermally coupled to the heat releasing section of the first cooling circuit.

An example of such a cooling system is disclosed in the European patent application no. 19168029.7 of the applicant. Furthermore, an example of a heat absorbing section of a second cooling circuit thermally coupled to a heat releasing section of a first cooling circuit in a heat exchanger arrangement suitable for the cooling system of the invention is disclosed in the European patent application no. 19168012.3 of the applicant.

By thermally coupling the heat releasing section of the first cooling circuit to the heat absorbing section of the second cooling circuit the cooling system can be operated advantageously in a first or passive mode, a second or hybrid mode and a third or active mode, in particular when the first cooling circuit is a passive cooling circuit and when the second cooling circuit is a an active cooling circuit. For example, when the interior temperature of the electronics cabinet is higher than the exterior or ambient temperature by a sufficient temperature delta for the first passive cooling circuit to work effectively, the cooling system may be operated in the passive mode only with the passive cooling circuit. When the interior temperature of the electronics cabinet is higher than the exterior or ambient temperature only by a temperature delta not sufficient for the first passive cooling circuit to work effectively, the second active cooling circuit can be operated in a hybrid mode to increase the cooling power of the cooling system. The hybrid mode is most advantageous when the first cooling circuit is configured as a thermosiphon, a heat pipe or pulsating heat pipe and when the second cooling circuit is configured as a vapor compression cycle circuit. The evaporator or heat absorbing section of the active cooling circuit in the hybrid mode cools the condensing side or heat releasing section of the heat pipe, thermosiphon or pulsating heat pipe, thereby lowering the temperature of the coolant or refrigerant in the heat pipe, thermosiphon or pulsating heat pipe. Since the temperature of the coolant or refrigerant in the heat pipe, thermosiphon or pulsating heat pipe is substantially homogeneous, the lower temperature of the coolant or refrigerant results in a lower temperature of the evaporating side or heat absorbing section of the heat pipe, thermosiphon or pulsating heat pipe. By lowering the temperature of the evaporating side or heat absorbing section of the passive cooling circuit the cooling power of the passive cooling circuit is increased. When the interior temperature of the electronics cabinet is lower than the exterior or ambient temperature, the cooling system can be operated in the active mode using only the active cooling circuit.

Preferably the cabinet side compartment comprises a fan configured to generate the airflow in the cabinet side compartment and/or the first external side compartment comprises a fan configured to generate an airflow in the first external side compartment and/or the second external side compartment comprises a fan configured to generate an airflow in the second external side compartment.

Thus, each of the cabinet side compartment, first external side compartment and second external side compartment can comprise a fan to generate a respective airflow though the respective compartment.

Still further, it is preferred that the fan of the cabinet side compartment is disposed in the direction of the airflow in the cabinet side compartment in front of or behind the heat absorbing section of the first cooling circuit and/or in front of or behind the heat absorbing section of the second cooling circuit, and/or that the fan of the first external side compartment is disposed in the direction of the airflow in the first external side compartment in front of or behind the heat releasing section of the first cooling circuit and/or in front of or behind the heat absorbing section of the second cooling circuit, and/or that the fan of the second external side compartment is disposed in the direction of the airflow in the second external side compartment in front of or behind the heat releasing section of the second cooling circuit.

In a configuration, in which the heat absorbing section of the first cooling circuit and the heat absorbing section of the second cooling circuit are both arranged in the cabinet side compartment, the fan in the cabinet side compartment may therefore be disposed in the direction of the airflow in front of or behind both heat absorbing sections or between the heat absorbing section of the first cooling circuit and the heat absorbing section of the second cooling circuit. In this configuration the fan in the first external side compartment may be disposed in front of or behind the heat releasing section of the first cooling circuit and the fan in the second external side compartment may be disposed in the direction of the airflow in front of or behind the heat releasing section of the second cooling circuit.

In a configuration in which the heat absorbing section of the second cooling circuit is arranged in the first external side compartment and thermally coupled to the heat releasing section of the first cooling circuit, the fan in the first external side compartment may be disposed in front of or behind both the heat releasing section of the first cooling circuit and the heat absorbing section of the second cooling circuit or the fan may be disposed between the heat releasing section of the first cooling circuit and the heat absorbing section of the second cooling circuit.

A further solution to the object of the present invention is the provision of an electronics cabinet comprising a cooling system as described above.

### Short description of the figures

The present invention is illustrated with reference to the accompanying figures:
- Fig. 1: shows a first configuration of a cooling system connected to an electronics cabinet,
- Fig. 2: shows a second configuration of a cooling system connected to an electronics cabinet,
- Fig. 3: shows a third configuration of a cooling system connected to an electronics cabinet, and
- Fig. 4: shows a fourth configuration of a cooling system connected to an electronics cabinet.

### Detailed description of the figures

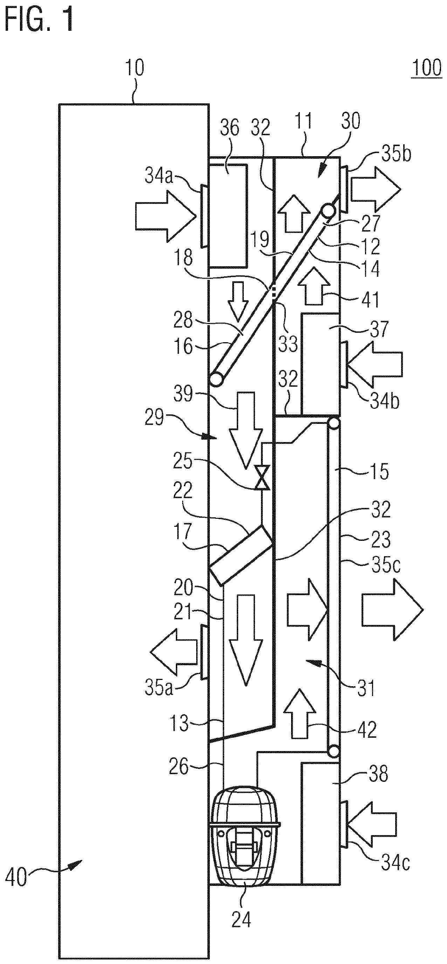

Fig. 1 shows a cooling system 100. The cooling system is connected to an electronics cabinet 10. The cooling system comprises a casing 11, a first cooling circuit 12 and a second cooling circuit 13. The first cooling circuit 12 comprises a heat releasing section 14. The second cooling circuit 13 also comprises a heat releasing section 15. In addition, the first cooling circuit 12 comprises a heat absorbing section 16 and the second cooling circuit 13 comprises a heat absorbing section 17. The first cooling circuit is configured as a passive cooling circuit 18 and, more particularly, as a pulsating heat pipe 19. The second cooling circuit 13 is configured as an active cooling circuit 20 and, more particularly, as a vapor compression cycle circuit 21. The vapor compression cycle circuit 21 comprises an evaporator 22, a condenser 23, a compressor 24, an expansion valve 25 and fluid lines 26 to interconnect these components. The condenser 23 is the heat releasing section 15 of the second cooling circuit 13 and the evaporator 22 is the heat absorbing section 17 of the second cooling circuit 13. Similarly, the pulsating heat pipe 19 comprises a condensing side 27 as the heat releasing section 14 of the first cooling circuit 12 and an evaporating side 28 as the heat absorbing section 16 of the first cooling circuit 12.

The casing 11 of the cooling system 100 is subdivided into a cabinet side compartment 29, a first external side compartment 30 and a second external side compartment 31. The cabinet side compartment 29, the first external side compartment 30 and the second external side compartment 31 are separated from each other by essentially gastight separation walls 32. The heat releasing section 14 of the first cooling circuit 12 is arranged in the first external side compartment 30 and the heat absorbing section 16 of the first cooling circuit 12 is arranged in the cabinet side compartment 29. Since the first cooling circuit 12 is configured as a pulsating heat pipe 19, the pulsating heat pipe 19 "sticks" through the separation wall 32 between the cabinet side compartment 29 and the first external side compartment 30. To prevent air from the cabinet side compartment 29 to enter the first external side compartment 30 a seal 33 is provided in the separation wall 32 separating the cabinet side compartment 29 and the first external side compartment 30 and surrounding the pulsating heat pipe 19. Furthermore, the heat absorbing section 17 of the second cooling circuit 13 is disposed in the cabinet side compartment 29 and the heat releasing section 15 of the second cooling circuit 13 is disposed in the second external side compartment 31. Each of the cabinet side compartment 29, the first external side compartment 30 and the second external side compartment 31 comprises respective inlet openings 34a, 34b, 34c and outlet openings 35a, 35b, 35c. A first fan 36 is disposed in the cabinet side compartment 29. A second fan 37 is disposed in the first external side compartment 30 and a third fan 38 is disposed in the second external side compartment 31. As indicated with arrows, fan 36 generates an airflow 39 in the cabinet side compartment 29 by driving air from an interior 40 of the electronics cabinet 10 through the inlet opening 34a of the cabinet side compartment 29. Airflow 39 passes over the heat absorbing section 16 of the first cooling circuit 12 and the heat absorbing section 17 of the second cooling circuit 13 and leaves the cabinet side compartment 29 via outlet opening 35a. Fan 36 is disposed in the direction of the airflow 39 in front of the heat absorbing section 16 of the first cooling circuit 12 and the heat absorbing section 17 of the second cooling circuit 13. Furthermore, with regard to the direction of airflow 39, the heat absorbing section 16 of the first cooling circuit 12 is disposed in front of the heat absorbing section 17 of the second cooling circuit 13. Similarly, fan 37 generates an airflow 41 in the first external side compartment 30. Ambient or external air enters the first external side compartment 30 through inlet opening 34b and exits the first external side compartment 30 through outlet opening 35b. The airflow 41 in the first external side compartment 30 passes over the heat releasing section 14 of the first cooling circuit 12. Thus, heat absorbed from the airflow 39 in the cabinet side compartment 29 by the heat absorbing section 16 is transferred to the heat releasing section 14 of the first cooling circuit 12 in the first external side compartment 30 and released to the ambient air via airflow 41. Fan 38 in the second external side compartment 31 generates airflow 42 in the second external side compartment 31. Ambient or external air enters the second external side compartment 31 via inlet opening 34c and exits the second external side compartment 31 via outlet opening 35c. Airflow 42 passes over the heat releasing section 15 of the second cooling circuit 13 so that heat absorbed by the heat absorbing section 17 from the airflow 39 in the cabinet side compartment 29 is released to the exterior via the heat releasing section 15 of the second cooling circuit 13. Both fans 37 and 38 are disposed with regard to the directions of the airflows 41 and 42 in front of the heat releasing section 14 of the first cooling circuit 12 and the heat releasing section 15 of the second cooling circuit 13, respectively.

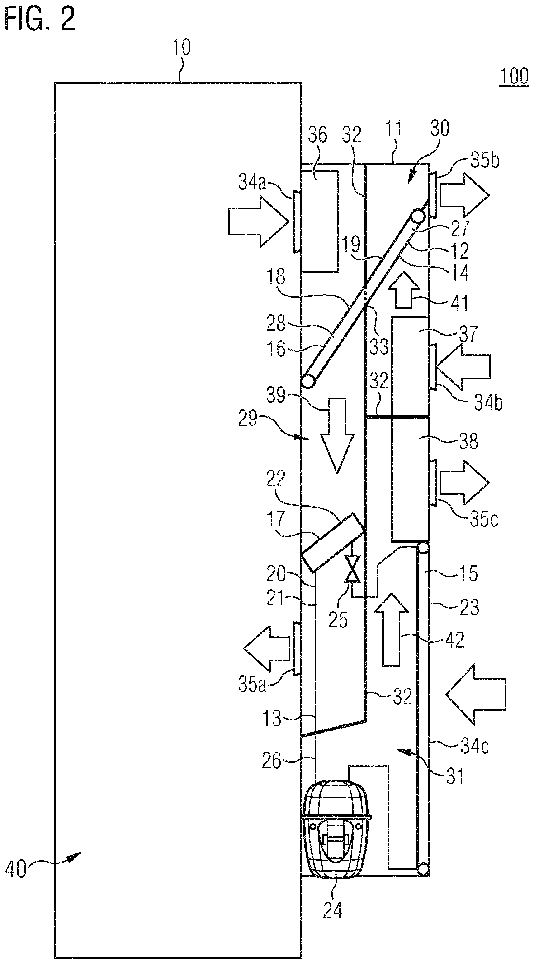

Fig. 2 shows a second configuration of a cooling system 100. The cooling system 100 is attached to an electronics cabinet 10. The cooling system 100 of Fig. 2 is essentially identical to the cooling system 100 of Fig. 1 and like reference numerals refer to corresponding components. The only difference between the cooling system 100 of Fig. 2 and the cooling system 100 of Fig. 1 is that second fan 38 in the second external side compartment 31 is disposed in the direction of the airflow 42 behind the heat releasing section 15 of the second cooling circuit 13.

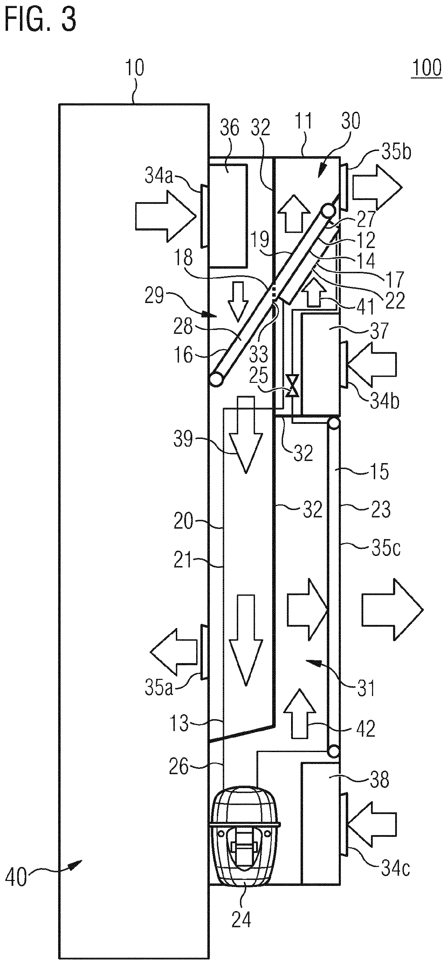

Fig. 3 shows a third configuration of the cooling system 100, which is similar to the cooling systems 100 of Fig. 1. Like reference numerals refer to corresponding components. In contrast to the cooling system 100 of Fig. 1 in the cooling system 100 of Fig. 3 the heat absorbing section 17 of the second cooling circuit 13 is not disposed in the cabinet side compartment 29, but is arranged in the first external side compartment 30 and thermally coupled to the heat releasing section 14 of the first cooling circuit 12. Thus, the heat absorbing section 17 of the second cooling circuit 13 cools the heat releasing section 14 of the first cooling circuit 12. In the configuration of Fig. 3 the first cooling circuit 12 is configured as a pulsating heat pipe 19 and the second cooling circuit 13 is configured as a vapor compression cycle circuit 21. The cooling system 100 of Fig. 3 can be particularly advantageously operated in the so-called hybrid mode when the interior temperature of the electronics cabinet 10 is higher than the exterior or ambient temperature only by a temperature delta not sufficient for the pulsating heat pipe 19 to work effectively. In this case, the evaporator 22 of the vapor compression cycle circuit 21 is used to cool the condensing side 27 of the pulsating heat pipe 19 and thereby lowers the temperature of a coolant or refrigerant in the pulsating heat pipe 19. Since the temperature of the refrigerant or coolant in the pulsating heat pipe 19 is essentially homogeneous over the full length of the pulsating heat pipe 19, the evaporating side 28 of the pulsating heat pipe 19 is cooled as well and thereby the efficiency of the pulsating heat pipe 19 is increased.

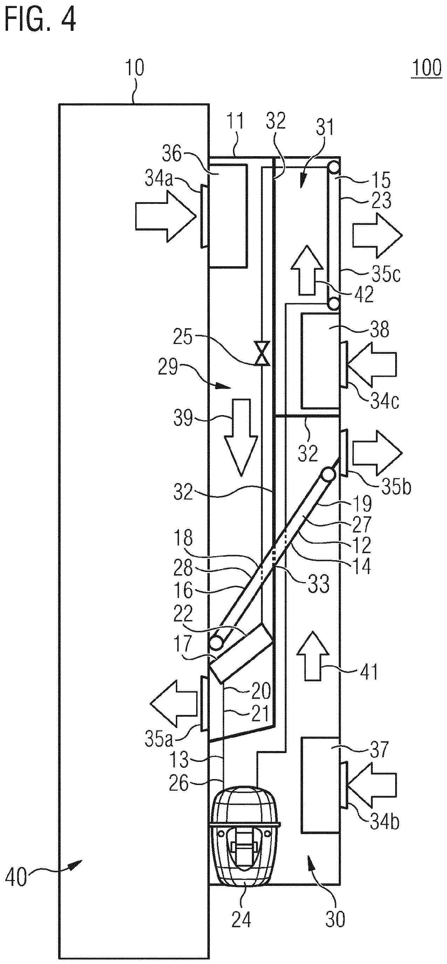

Fig. 4 shows a fourth configuration of the cooling system 100, which is similar to the cooling systems 100 of Fig. 1. Like reference numerals refer to corresponding components. In contrast to the cooling system of Fig. 1, in the cooling system 100 of Fig. 4 the first external side compartment 30 and the second side external compartment 31 are swapped, i.e. in the cooling system 100 of Fig. 4 the first external side compartment 30 is located below the second side external compartment 31, while in Fig. 1 the first external side compartment 30 is located above the second side external compartment 31. In the configuration of Fig.1 warm air from airflow 42 can exit second external side compartment 31 through outlet opening 35c and enter first external side compartment 30 through inlet opening 34b. This short circuiting of warm airflows 42 and 41 can result in a warming of the condensing side 27 of pulsating heat pipe 19. Since the pulsating heat pipe 19 is a passive cooling circuit 18, warming of the condensing side 27 of pulsating heat pipe 19 reduces the cooling power of the pulsating heat pipe 19. Returning to the configuration of Fig. 4, the condensing side 27 of pulsating heat pipe 19 is disposed in first external side compartment 30, which is arranged below second external side compartment 31. Thus, because warm air rises, warm air from airflow 42 from second external side compartment 31 exiting through outlet opening 35c cannot enter first external side compartment 30 through inlet opening 34b. This arrangement of first external side compartment 30 and second external side compartment 31 prevents the warming of the condensing side 27 of pulsating heat pipe 19 and therefore ensures a high cooling power of the passive cooling circuit 18 of the pulsating heat pipe 19. Although short circuiting of airflows 41, 42 is still possible, i.e. warm air from airflow 41 can exit first external side compartment 30 through outlet opening 35b and enter second external side compartment 31 through inlet opening 34c, the resulting warming of condenser 23 of vapor compression cycle circuit 21 does not considerably impact the total cooling power of cooling system 100 because the cooling power of vapor compression cycle circuit 21 can be increased by adjusting its operating parameters.

### List of reference numerals

- 100: Cooling system

- 10: Electronics cabinet
- 11: Casing
- 12: First cooling circuit
- 13: Second cooling circuit
- 14: Heat releasing section of first cooling circuit
- 15: Heat releasing section of second cooling circuit
- 16: Heat absorbing section of first cooling circuit
- 17: Heat absorbing section of second cooling circuit
- 18: Passive cooling circuit
- 19: Pulsating heat pipe

- 20: Active cooling circuit
- 21: Vapor compression cycle circuit
- 22: Evaporator
- 23: Condenser
- 24: Compressor
- 25: Expansion valve
- 26: Fluid lines
- 27: Condensing side
- 28: Evaporating side
- 29: Cabinet side compartment

- 30: First external side compartment
- 31: Second external side compartment
- 32: Separation walls
- 33: Seal
- 34a: Inlet opening
- 34b: Inlet opening
- 34c: Inlet opening
- 35a: outlet opening
- 35b: outlet opening
- 35c: outlet opening
- 36: Fan of cabinet side compartment
- 37: Fan of first external side compartment
- 38: Fan of second external side compartment
- 39: Airflow in cabinet side compartment

- 40: Interior
- 41: Airflow in first external side compartment
- 42: Airflow in second external side compartment

## Claims

1. Cooling system (100), in particular for electronics cabinets (10), comprising a casing (11), wherein the cooling system (100) comprises a first cooling circuit (12) and a second cooling circuit (13), the first cooling circuit (12) comprising a heat releasing section (14) and the second cooling circuit (13) comprising a heat releasing section (15), wherein the first cooling circuit (12) comprises a heat absorbing section (16) and wherein the second cooling circuit (13) comprises a heat absorbing section (17), wherein
the casing (11) comprises at least three compartments (29, 30, 31) including a cabinet side compartment (29), a first external side compartment (30) and a second external side compartment (31), wherein the three compartments (29, 30, 31) are fluidically separated from each other so that respective airflows (39, 41, 42) in the cabinet side compartment (29), the first external side compartment (30) and the second external side compartment (31) do not mix, wherein the heat releasing section (14) of the first cooling circuit (12) is arranged in the first external side compartment (30) and wherein the heat releasing section (15) of the second cooling circuit (13) is arranged in the second external side compartment (31), **characterized in**
**that** the heat absorbing section (16) of the first cooling circuit (12) and the heat absorbing section (17) of the second cooling circuit (13) are arranged in the cabinet side compartment (29), and that the heat absorbing section (16) of the first cooling circuit (12) is disposed in the direction of an airflow (39) in the cabinet side compartment (29) in front of the heat absorbing section (17) of the second cooling circuit (13), or
**that** the heat absorbing section (16) of the first cooling circuit (12) is arranged in the cabinet side compartment (29) and that the heat absorbing section (17) of the second cooling circuit (13) is arranged in the first external side compartment (30) and thermally coupled to the heat releasing section (14) of the first cooling circuit (12).

2. Cooling system (100) according to claim 1, **characterized in that** the cabinet side compartment (29) is fluidically connectable or connected to an interior (40) of an electronics cabinet (10), and/or that the first external side compartment (30) is fluidically connectable or connected to an exterior of an electronics cabinet (10), and/or that the second external side compartment (31) is fluidically connectable or connected to an exterior of an electronics cabinet (10).

3. Cooling system (100) according to claim 1 or 2, **characterized in that** the first cooling circuit (12) is a passive cooling circuit (18), in particular a heat pipe, a thermosiphon or a pulsating heat pipe (19), wherein the heat releasing section (14) of the first cooling circuit (12) preferably is a condensing side (27) of the passive cooling circuit (18).

4. Cooling system (100) according to any one of the preceding claims, **characterized in that** the second cooling circuit (13) is an active cooling circuit (20), in particular a vapor compression cycle circuit (21), wherein the heat releasing section (15) of the second cooling circuit (13) is preferably a condenser (23) of the active cooling circuit (20).

5. Cooling system (100) according to any one of the preceding claims, **characterized in that** the cabinet side compartment (29) comprises a fan (36) configured to generate the airflow (39) in the cabinet side compartment (29) and/or that the first external side compartment (30) comprises a fan (37) configured to generate an airflow (41) in the first external side compartment (30) and/or that the second external side compartment (31) comprises a fan (38) configured to generate an airflow (42) in the second external side compartment (31).

6. Cooling system (100) according to claim 5, **characterized in that** the fan (36) of the cabinet side compartment (29) is disposed in the direction of the airflow (39) in the cabinet side compartment (29) in front of or behind the heat absorbing section (16) of the first cooling circuit (12) and/or in front of or behind the heat absorbing section (17) of the second cooling circuit (13), and/or that the fan (37) of the first external side compartment (30) is disposed in the direction of the airflow (41) in the first external side compartment (30) in front of or behind the heat releasing section (14) of the first cooling circuit (12) and/or in front of or behind the heat absorbing section (17) of the second cooling circuit (13), and/or that the fan (38) of the second external side compartment (31) is disposed in the direction of the airflow (42) in the second external side compartment (31) in front of or behind the heat releasing section (15) of the second cooling circuit (13).

7. Electronics cabinet (10) comprising a cooling system (100) according to any one of claims 1 to 6.

## Patentansprüche

1. Kühlsystem (100), insbesondere für Elektronikschränke (10), umfassend ein Gehäuse (11), wobei das Kühlsystem (100) einen ersten Kühlkreislauf (12) und einen zweiten Kühlkreislauf (13) umfasst, der erste Kühlkreislauf (12) einen wärmeabgebenden Abschnitt (14) umfasst und der zweite Kühlkreislauf (13) einen wärmeabgebenden Abschnitt (15) umfasst, wobei der erste Kühlkreislauf (12) einen wärmeabsorbierenden Abschnitt (16) umfasst und wobei der zweite Kühlkreislauf (13) einen wärmeabsorbierenden Abschnitt (17) umfasst, wobei das Gehäuse (11) mindestens drei Fächer (29, 30, 31) umfasst, einschließlich eines schrankseitigen Fachs (29), eines ersten außenseitigen Fachs (30) und eines zweiten außenseitigen Fachs (31), wobei die drei Fächer (29, 30, 31) fluidisch voneinander getrennt sind, so dass jeweilige Luftströme (39, 41, 42) in dem schrankseitigen Fach (29), dem ersten außenseitigen Fach (30) und dem zweiten außenseitigen Fach (31) sich nicht vermischen, wobei der wärmeabgebende Abschnitt (14) des ersten Kühlkreislaufs (12) in dem ersten außenseitigen Fach (30) angeordnet ist und wobei der wärmeabgebende Abschnitt (15) des zweiten Kühlkreislaufs (13) in dem zweiten außenseitigen Fach (31) angeordnet ist, **dadurch gekennzeichnet, dass**
der wärmeabsorbierende Abschnitt (16) des ersten Kühlkreislaufs (12) und der wärmeabsorbierende Abschnitt (17) des zweiten Kühlkreislaufs (13) in dem schrankseitigen Fach (29) angeordnet sind, und dass der wärmeabsorbierende Abschnitt (16) des ersten Kühlkreislaufs (12) in Richtung eines Luftstroms (39) im schrankseitigen Fach (29) vor dem wärmeabsorbierenden Abschnitt (17) des zweiten Kühlkreislaufs (13) angeordnet ist, oder
dass der wärmeabsorbierende Abschnitt (16) des ersten Kühlkreislaufs (12) im schrankseitigen Fach (29) angeordnet ist und dass der wärmeabsorbierende Abschnitt (17) des zweiten Kühlkreislaufs (13) in dem ersten außenseitigen Fach (30) angeordnet und mit dem wärmeabgebenden Abschnitt (14) des ersten Kühlkreislaufs (12) thermisch gekoppelt ist.

2. Kühlsystem (100) gemäß Anspruch 1, **dadurch gekennzeichnet, dass** das schrankseitige Fach (29) mit einem Innenraum (40) eines Elektronikschranks (10) fluidisch verbindbar oder verbunden ist und/oder dass das erste außenseitige Fach (30) mit einer Außenseite eines Elektronikschranks (10) fluidisch verbindbar oder verbunden ist, und/oder dass das zweite außenseitige Fach (31) mit einer Außenseite eines Elektronikschranks (10) fluidisch verbindbar oder verbunden ist.

3. Kühlsystem (100) gemäß Anspruch 1 oder 2, **dadurch gekennzeichnet, dass** der erste Kühlkreislauf (12) ein passiver Kühlkreislauf (18), insbesondere ein Wärmerohr, ein Thermosiphon oder ein pulsierendes Wärmerohr (19) ist, wobei der wärmeabgebende Abschnitt (14) des ersten Kühlkreislaufs (12) vorzugsweise eine Kondensationsseite (27) des passiven Kühlkreislaufs (18) ist.

4. Kühlsystem (100) gemäß einem der vorhergehenden Ansprüche, **dadurch gekennzeichnet, dass** der zweite Kühlkreislauf (13) ein aktiver Kühlkreislauf (20), insbesondere ein Dampfkompressionskreislauf (21) ist, wobei der wärmeabgebende Abschnitt (15) des zweiten Kühlkreislaufs (13) vorzugsweise ein Kondensator (23) des aktiven Kühlkreislaufs (20) ist.

5. Kühlsystem (100) gemäß einem der vorhergehenden Ansprüche, **dadurch gekennzeichnet, dass** das schrankseitige Fach (29) einen Lüfter (36) umfasst, der so konfiguriert ist, dass er den Luftstrom (39) in dem schrankseitigen Fach (29) erzeugt und/oder dass das erste außenseitige Fach (30) einen Lüfter (37) umfasst, der so konfiguriert ist, dass er einen Luftstrom (41) in dem ersten außenseitigen Fach (30) erzeugt, und/oder dass das zweite außenseitige Fach (31) einen Lüfter (38) umfasst, der so konfiguriert ist, dass er einen Luftstrom (42) in dem zweiten außenseitigen Fach (31) erzeugt.

6. Kühlsystem (100) gemäß Anspruch 5, **dadurch gekennzeichnet, dass** der Lüfter (36) des schrankseitigen Fachs (29) in Richtung des Luftstroms (39) im schrankseitigen Fach (29) vor oder hinter dem wärmeabsorbierenden Abschnitt (16) des ersten Kühlkreislaufs (12) und/oder vor oder hinter dem wärmeabsorbierenden Abschnitt (17) des zweiten Kühlkreislaufs (13) angeordnet ist, und/oder dass der Lüfter (37) des ersten außenseitigen Fachs (30) in Richtung des Luftstroms (41) im ersten außenseitigen Fach (30) vor oder hinter dem wärmeabgebenden Abschnitt (14) des ersten Kühlkreislaufs (12) und/oder vor oder hinter dem wärmeabsorbierenden Abschnitt (17) des zweiten Kühlkreislaufs (13) angeordnet ist und/oder dass der Lüfter (38) des zweiten außenseitigen Fachs (31) in Richtung des Luftstroms (42) im zweiten außenseitigen Fach (31) vor oder hinter dem wärmeabgebenden Abschnitt (15) des zweiten Kühlkreislaufs (13) angeordnet ist.

7. Elektronikschrank (10), umfassend ein Kühlsystem (100) nach einem der Ansprüche 1 bis 6.

## Revendications

1. Système de refroidissement (100), en particulier pour armoires électroniques (10), comprenant une enceinte (11), sachant que le système de refroidissement (100) comprend un premier circuit de refroidissement (12) et un deuxième circuit de refroidissement (13), le premier circuit de refroidissement (12) comprenant une section libérant de la chaleur (14) et le deuxième circuit de refroidissement (13) comprenant une section libérant de la chaleur (15), sachant que le premier circuit de refroidissement (12) comprend une section absorbant la chaleur (16) et sachant que le deuxième circuit de refroidissement (13) comprend une section absorbant la chaleur (17), sachant que
l'enceinte (11) comprend au moins trois compartiments (29, 30, 31) incluant un compartiment côté armoire (29), un premier compartiment du côté extérieur (30) et un deuxième compartiment du côté extérieur (31), sachant que les trois compartiments (29, 30, 31) sont séparés l'un de l'autre en matière de fluide de telle manière que les flux d'air respectifs (39, 41, 42) dans le compartiment côté armoire (29), le premier compartiment du côté extérieur (30) et le deuxième compartiment du côté extérieur (31) ne se mélangent pas, sachant que la section libérant de la chaleur (14) du premier circuit de refroidissement (12) est disposée dans le premier compartiment du côté extérieur (30) et sachant que la section libérant de la chaleur (15) du deuxième circuit de refroidissement (13) est disposée dans le deuxième compartiment du côté extérieur (31), **caractérisé en ce que**
la section absorbant la chaleur ((16) du premier circuit de refroidissement (12) et la section absorbant la chaleur (17) du deuxième circuit de refroidissement (13) sont disposées dans le compartiment côté armoire (29) et **en ce que** la section absorbant la chaleur (16) du premier circuit de refroidissement (12) est disposée dans la direction d'un flux d'air (39) dans le compartiment côté armoire (29) en face de la section absorbant la chaleur (17) du deuxième circuit de refroidissement (13), ou
**en ce que** la section absorbant la chaleur (16) du premier circuit de refroidissement (12) est disposée dans le compartiment côté armoire (29) et **en ce que** la section absorbant la chaleur (17) du deuxième circuit de refroidissement (13) est disposée dans le premier compartiment du côté extérieur (30) et est thermiquement couplée à la section libérant de la chaleur (14) du premier circuit de refroidissement (12).

2. Système de refroidissement (100) selon la revendication 1, **caractérisé en ce que** le compartiment côté armoire (29) peut être raccordé ou est raccordé en matière de fluide à un intérieur (40) d'une armoire électronique (10) et/ou **en ce que** le premier compartiment du côté extérieur (30) peut être raccordé ou est raccordé en matière de fluide à un extérieur d'une armoire électronique (10) et/ou **en ce que** le deuxième compartiment du côté extérieur (31) peut être raccordé ou est raccordé en matière de fluide à un extérieur d'une armoire électronique (10).

3. Système de refroidissement (100) selon la revendication 1 ou 2, **caractérisé en ce que** le premier circuit de refroidissement (12) est un circuit de refroidissement passif (18), en particulier un conduit de chaleur, un thermosiphon ou un conduit de chaleur pulsatoire (19), sachant que la section libérant de la chaleur (14) du premier circuit de refroidissement (12) est de préférence un côté de condensation (27) du circuit de refroidissement passif (18).

4. Système de refroidissement (100) selon l'une quelconque des revendications précédentes, **caractérisé en ce que** le deuxième circuit de refroidissement (13) est un circuit de refroidissement actif (20), en particulier un circuit à cycle de compression de vapeur (21), sachant que la section libérant de la chaleur (15) du deuxième circuit de refroidissement (13) est de préférence un condenseur (23) du circuit de refroidissement actif (20).

5. Système de refroidissement (100) selon l'une quelconque des revendications précédentes, **caractérisé en ce que** le compartiment côté armoire (29) comprend un ventilateur (36) configuré pour produire le flux d'air (39) dans le compartiment côté armoire (29) et/ou **en ce que** le premier compartiment du côté extérieur (30) comprend un ventilateur (37) configuré pour produire un flux d'air (41) dans le premier compartiment du côté extérieur (30) et/ou **en ce que** le deuxième compartiment du côté extérieur (31) comprend un ventilateur (38) configuré pour produire un flux d'air (42) dans le deuxième compartiment du côté extérieur (31).

6. Système de refroidissement (100) selon la revendication 5, **caractérisé en ce que** le ventilateur (36) du compartiment côté armoire (29) est disposé dans la direction du flux d'air (39) dans le compartiment côté armoire (29) en face ou derrière la section absorbant la chaleur (16) du premier circuit de refroidissement (12) et/ou en face ou derrière la section absorbant la chaleur (17) du deuxième circuit de refroidissement (13) et/ou **en ce que** le ventilateur (37) du premier compartiment du côté extérieur (30) est disposé dans la direction du flux d'air (41) dans le premier compartiment du côté extérieur (30) en face ou derrière la section libérant la chaleur (14) du premier circuit de refroidissement (12) et/ou en face ou derrière la section absorbant la chaleur (17) du deuxième circuit de refroidissement (13) et/ou **en ce que** le ventilateur (38) du deuxième compartiment du côté extérieur (31) est disposé dans la direction du flux d'air (42) dans le deuxième compartiment du côté extérieur (31) en face ou derrière la section libérant la chaleur (15) du deuxième circuit de refroidissement (13).

7. Armoire électronique (10) comprenant un système de refroidissement (100) selon l'une quelconque des revendications 1 à 6.
